# EUROPÄISCHE PATENTSCHRIFT

(11) **EP 2 991 888 B1**
(45) Veröffentlichungstag und Bekanntmachung des Hinweises auf die Patenterteilung: **31.05.2017**
(21) Anmeldenummer: 14721323.5
(22) Anmeldetag: 29.04.2014
(51) Int. Cl.: B62D 5/04

(54) **AUFNAHMEVORRICHTUNG FÜR EINE EINEN ELEKTROMOTOR EINER HILFSKRAFTUNTERSTÜTZUNG EINER FAHRZEUGLENKUNG ANSTEUERNDEN STEUERSCHALTUNG**
RECEPTACLE FOR A CONTROL CIRCUIT THAT CONTROLS AN ELECTRIC MOTOR FOR POWER ASSISTANCE IN A VEHICLE STEERING SYSTEM
DISPOSITIF DE RÉCEPTION POUR UN CIRCUIT DE COMMANDE COMMANDANT UN MOTEUR ÉLECTRIQUE D'UNE ASSISTANCE D'UNE DIRECTION DE VÉHICULE

(30) Priorität: 29.04.2013 DE 102013104358
(43) Veröffentlichungstag der Anmeldung: 09.03.2016
(73) Patentinhaber: ThyssenKrupp Presta Aktiengesellschaft, 9492 Eschen (LI)
(72) Erfinder: SCHOLTEN, Michael, A-6723 Blons (AT)
(74) Vertreter: ThyssenKrupp Intellectual Property GmbH
(86) Internationale Anmeldenummer: PCT/EP2014/058696
(87) Internationale Veröffentlichungsnummer: WO 2014/177549

(56) Entgegenhaltungen:
- EP-A2- 2 371 673
- DE-A1-102010 037 226
- US-A1- 2012 229 005

## Beschreibung

### Technisches Gebiet

Die vorliegende Erfindung betrifft eine Aufnahmevorrichtung für eine einen Elektromotor einer Hilfskraftunterstützung einer Fahrzeuglenkung ansteuernden Steuerschaltung, bevorzugt zur Aufnahme einer Steuerschaltung eines Elektromotors einer Hilfskraftunterstützung für eine Kraftfahrzeuglenkung.

### Stand der Technik

Im Bereich der Hilfskraftunterstützungen für Fahrzeuglenkungen, beispielsweise im Bereich von Servolenkungen, ist es bekannt, einen Elektromotor vorzusehen, über welchen das Drehmoment zur Hilfskraftunterstützung auf die entsprechende Fahrzeuglenkung beziehungsweise das entsprechende Lenkgetriebe aufgebracht wird. Eine Hilfskraftunterstützung besteht dabei üblicherweise aus einer Steuerschaltung (ECU) und einem Elektromotor, welcher von dieser ECU angesteuert wird. Die Hilfskraftunterstützung kann dabei eine Unterstützungskraft, also ein Unterstützungsdrehmoment, bereitstellen, welches die von einem Fahrer über ein Lenkrad eingebrachten Betätigungskräfte reduzieren soll. Eine Hilfskraftunterstützung kann weiterhin aber auch einen Zusatzlenkwinkel bereitstellen, beispielsweise bei einer Überlagerungslenkung, bei welcher der vom Fahrer eingebrachte Lenkwinkel durch eine zusätzliche Übersetzung verändert wird. Mittels einer solchen Hilfskraftunterstützung können beispielsweise auch zusätzliche Lenkbewegungen eingetragen werden, beispielsweise bei einer automatischen Spurhaltung des Fahrzeugs oder zum automatischen Einparken.

Der Elektromotor wird dabei üblicherweise über eine Steuerschaltung angesteuert, wobei die Steuerschaltung eine Motorsteuerung umfasst und Leistungsschalter zum Steuern der Leistungsströme für den Elektromotor vorgesehen sind. Beispielsweise können MOSFET's vorgesehen sein, mittels welchen der Leistungsstrom, welcher dem Elektromotor zugeführt wird, gesteuert wird.

Die bekannten Steuerschaltungen, welche neben dem einen oder mehreren Leistungsschaltern auch eine Steuerelektronik umfassen, sind üblicherweise mit den das Drehmoment aufbringenden Elektromotoren verbunden und sind mittels eines Gehäuses gegenüber Umwelteinflüssen geschützt.

Bei elektrischen Hilfskraftunterstützungen ist es gewünscht, eine kompakte Baugruppe aus Elektromotor, elektronischer Steuerschaltung und eventuell einem Getriebe, mittels welchem das elektromotorische Drehmoment in das Lenksystem eingeleitet wird, auszubilden. Hierbei soll bevorzugt eine gute Wärmeableitung der Leistungsschaltelemente, welche die Bestromung des Elektromotors steuern, gewährleistet werden. Weiterhin muss eine gute Abdichtung gegen Umwelteinflüsse, wie Staub, Schmutz und Feuchtigkeit über die gesamte Lebensdauer der Hilfskraftunterstützung bereitgestellt werden.

Eine solche Anordnung ist beispielsweise aus der DE 10 2007 048 075 A1 bekannt, bei welcher die Steuerschaltung über einen an den Elektromotor angeflanschten Gehäusedeckel vor Umwelteinflüssen geschützt ist.

Aus der DE 10 2009 029 538 A1 ist eine Lenkvorrichtung, insbesondere eine elektrische Servolenkvorrichtung für ein Kraftfahrzeug, bekannt, bei welcher eine elektrische Steuereinheit über Flansche am Gehäuse des Elektromotors befestigt ist.

Da die Elektronik und die Leistungsbauelemente sehr empfindlich gegenüber Staub, Spänen oder anderen Verschmutzungen sind, muss die Montage der entsprechenden Elektronikbauteile an dem Elektromotor in einem Reinraum durchgeführt werden, und jeder Eintrag von Staub, Schmutz und Spänen in das Gehäuse der elektronischen Steuerschaltung muss verhindert werden. Schmutz, Staub oder Späne können nämlich zu Kurzschlüssen führen, welche schlussendlich ein Sicherheitsrisiko durch die Lenkkraftunterstützung darstellen würden.

Aus der US 2012/229005 A1 ist eine Aufnahmevorrichtung für eine einen Elektromotor einer Hilfskraftunterstützung einer Fahrzeuglenkung ansteuernde Steuerschaltung bekannt. Diese umfasst ein Gehäuse zur Aufnahme der Steuerschaltung, welches eine Öffnung zum Einführen der Steuerschaltung in das Gehäuse aufweist, und eine Bodenplatte zum staubdichten Verschließen der Öffnung des Gehäuses in einer Endposition. Diese erfordert ebenfalls eine Montage unter Reinraumbedingungen.

### Darstellung der Erfindung

Ausgehend von dem bekannten Stand der Technik ist es eine Aufgabe der vorliegenden Erfindung, eine Aufnahmevorrichtung für eine Steuerschaltung bereitzustellen, mittels welcher eine einfache und sichere Montage einer Hilfskraftunterstützung erreicht werden kann.

Die Aufgabe wird durch eine Aufnahmevorrichtung mit den Merkmalen des Anspruchs 1 gelöst. Vorteilhafte Weiterbildungen ergeben sich aus den Unteransprüchen.

Entsprechend wird eine Aufnahmevorrichtung für eine einen Elektromotor einer Hilfskraftunterstützung einer Fahrzeuglenkung ansteuernden Steuerschaltung vorgeschlagen, welche ein Gehäuse zur Aufnahme der Steuerschaltung umfasst, wobei das Gehäuse eine Öffnung zum Einführen der Steuerschaltung in das Gehäuse aufweist, und eine Bodenplatte zum staubdichten Verschließen der Öffnung des Gehäuses in einer Endposition aufweist. Erfindungsgemäß sind die Bodenplatte und das Gehäuse in einer von der Endposition verschiedenen Lieferposition staubdicht miteinander verbindbar.

Dadurch, dass die Bodenplatte und das Gehäuse in einer von der Endposition verschiedenen Lieferposition staubdicht miteinander verbindbar sind, kann erreicht werden, dass in der Lieferposition bereits eine staubdichte Abdichtung der in dem Gehäuse aufgenommenen Steuerschaltung erreicht wird. Die Steuerschaltung ist damit entsprechend in der Lieferposition bereits vollständig gegen äußere schädliche Einflüsse, wie beispielsweise Staub, Späne oder Schmutz geschützt und kann dann zum Verbinden mit dem entsprechenden Elektromotor der Hilfskraftunterstützung ohne erneutes Öffnen des Gehäuses herangezogen werden. Mit Vorteil ist der Elektromotor in einem Gehäuse eingeschlossen, das zumindest eine Motorgehäusebodenplatte, einen Motorgehäusedeckel und einen Motorgehäusemantel umfasst, wodurch eine Motorbaugruppe gebildet ist. Mit Vorzug ist im Motorgehäusedeckel und/oder in der Motorgehäusebodenplatte ein Lagerung der Motorwelle vorgesehen, so dass der Motorgehäusedeckel und/oder die Motorgehäusebodenplatte auch als Lagerplatte ausgebildet sein kann.

Damit kann eine einfache Vormontage der Aufnahmevorrichtung zusammen mit der Steuerschaltung beispielsweise in einem Reinraum vorgenommen werden und dann die Aufnahmevorrichtung mit der fertig montierten Steuerschaltung in der Lieferposition ausgeliefert werden. Beim nachfolgenden Zusammenbauen mit dem Elektromotor oder der bevorzugten Motorbaugruppe der Hilfskraftunterstützung muss dann entsprechend keine Öffnung der Aufnahmevorrichtung beziehungsweise des Gehäuses mehr stattfinden, sondern die Aufnahmevorrichtung mit der fertig montierten Steuerschaltung kann direkt mit dem Elektromotor oder der Motorbaugruppe verbunden werden. Die Steuerschaltung ist damit staubfrei in der Aufnahmevorrichtung aufgenommen, so dass ein sicherer Transport und eine sichere Hochzeit zwischen Elektromotor oder Motorbaugruppe und Steuerschaltung vorgenommen werden kann, welche nicht in einem Reinraum durchgeführt werden muss. Bei der Anordnung des Elektromotors in der Motorbaugruppe kann auch hier eine geschlossene Abdichtung vogesehen sein, so dass auch der Elektromotor sicher gegen Staubeinwirkung auf seinem Transport zum Montagewerk geschützt ist. Mit Vorteil sind Anschlussdrähte zur elektrischen Kontaktierung der Motorwicklungen aus der Motorbaugruppe herausgeführt, um mit einer Steuerung, insbesondere der in der Aufnahmevorrichtung angeordneten Steuerschaltung, bei der Montage verbunden zu werden.

Besonders bevorzugt ist mindestens eine Montageöffnung in der Bodenplatte vorgesehen, durch welche hindurch ein durch die Bodenplatte hindurch geführter Kontakt der Steuerschaltung in der Lieferposition frei zugänglich ist. Damit kann eine Kontaktierung des Elektromotors, beispielsweise zur Kontaktierung einer Wicklung des Elektromotors derart, dass leitende Verbindungen zwischen in der Aufnahmevorrichtung aufgenommenen MOSFET's der Steuerschaltung mit der entsprechenden Wicklung des Elektromotors ausgebildet werden, durch die Montageöffnung hindurch erreicht werden. Der durch die Bodenplatte hindurch geführte Kontakt ist dabei im Lieferzustand bevorzugt frei zugänglich, so dass der Kontakt zwischen der Steuerschaltung und dem Elektromotor hergestellt werden kann. Hier wird bevorzugt durch ein durch die Montageöffnung hindurch geführtes Werkzeug eine dauerhafte Verbindung der Kontakte mittels Schweißen, Löten, Krimpen oder einer anderen Art des Bondings hergestellt. Insbesondere ermöglicht die Montageöffnung in der Bodenplatte eine sehr gute Verbindbarkeit der Aufnahmevorrichtung mit der Motorbaugruppe, da keine Montagevorgänge innerhalb der Motorbaugruppe erforderlich sind. Hierzu werden die Motorbaugruppe und die Aufnahmevorrichtung durch Verbinden der Bodenplatte mit dem Motorgehäusedeckel und/oder dem Motorgehäusemantel miteinander verbunden und daran anschließend die elektrischen Kontakte, wie oben beschrieben, verbunden.

In der Endposition ist die Montageöffnung und damit der Zugang zu den Kontakten dann bevorzugt im Gehäuse der Aufnahmevorrichtung aufgenommen, so dass die Baugruppe als Ganze staubdicht ausgeführt ist. Mit anderen Worten ist in der Endposition die Montageöffnung verschlossen.

Damit wird es auf diese Weise ermöglicht, die bereits staubdicht in der Aufnahmevorrichtung aufgenommene Steuerschaltung mit dem Elektromotor oder der Motorbaugruppe leitend zu verbinden, da die entsprechenden Kontakte im Lieferzustand frei zugänglich sind. In der Endposition wird dann ein vollständig staubdichtes Verschließen der gesamten Baugruppe, bestehend aus der Aufnahmevorrichtung und dem Elektromotor oder Motorbaugruppe, erreicht. Damit sind die einzelnen Schritte des Zusammenbauens von Steuerschaltung und Elektromotor der Hilfskraftunterstützung sicher und einfach möglich, wobei die Steuerschaltung beim Zusammenbauen stets staubgeschützt im Gehäuse aufgenommen ist und nachfolgend die Kontakte zur Kontaktierung des Elektromotors durch die Steuerschaltung ebenfalls in dem Gehäuse aufgenommen sind, insbesondere bei der Ausbildung einer Motorbaugruppe.

Zur Bereitstellung der Lieferposition sowie der Endposition ist bevorzugt eine erste Rastvorrichtung zum Halten der Lieferposition und eine zweite Rasvorrichtung zum Halten der Endposition des Gehäuses bezüglich der Bodenplatte vorgesehen. Die entsprechenden Rastvorrichtungen werden bevorzugt durch im Gehäuse und an der Bodenplatte vorgesehene mechanische, miteinander korrespondierende Rastnasen beziehungsweise Rastausnehmungen bereitgestellt.

Besonders bevorzugt ist eine manipulationssichere Verbindung zumindest in der Lieferposition derart vorgesehen, dass ein erneutes Öffnen der Aufnahmevorrichtung von der Lieferposition ausgehend erkannt werden kann. Hierdurch kann sichergestellt werden, dass bei einer Montage der Aufnahmevorrichtung erkannt wird, ob sich die Steuerschaltung in dem ursprünglichen, staubdicht und staubfrei in das Gehäuse eingebauten Zustand befindet, oder ob dieser Zustand eventuell kompromittiert wurde. Entsprechend lässt sich auf diese Weise eine Qualitätssicherung für die ganze Baugruppe erreichen.

Eine solche manipulationssichere Verbindung kann beispielsweise dadurch bereitgestellt werden, dass in einer Verbindung des Gehäuses mit der Bodenplatte in der Lieferposition eine solche Verrastung beispielsweise einen Widerhaken umfasst, der beim erneuten Öffnen des Gehäuses ein Abscheren eines Dichtrings oder das Abbrechen von anderen Befestigungselementen bewirkt. Ein derartiger Widerhaken kann auch durch ein in eine Vertiefung eingelassenes separates Hakenteil, das beispielsweise als einfaches gebogenes Blechteil ausgebildet ist, dargestellt werden. Dieses separate Hakenteil wirkt bevorzugt mit einem nach innen gerichteten Vorsprung im Gehäuse der Aufnahmevorrichtung zusammen. So kann sichergestellt werden, dass die tatsächlich mit einem Elektromotor einer Hilfskraftunterstützung verbundenen Steuerschaltungen in integeren Aufnahmevorrichtungen aufgenommen sind.

Bevorzugt sind eine erste Dichtung zum Abdichten des Gehäuses gegenüber der Bodenplatte in der Lieferposition und eine zweite Dichtung zum Abdichten des Gehäuses gegenüber der Bodenplatte in der Endposition vorgesehen, wobei bevorzugt zwischen der ersten Dichtung und der zweiten Dichtung eine Montageöffnung vorgesehen ist, durch welche hindurch ein durch die Bodenplatte hindurch geführter Kontakt der Steuerschaltung in der Lieferposition frei zugänglich ist.

Um eine gute Wärmeableitung der Leistungsschaltelemente der Steuerschaltung zu erreichen, ist bevorzugt ein wärmeleitendes Trägerelement für die Steuerschaltung vorgesehen, bevorzugt für die Leistungsschalter der Steuerschaltung, welche in wärmeleitender Verbindung mit der Bodenplatte und/oder einer Stirnplatte stehen.

Eine besonders bevorzugte Ausgestaltung des Gehäuses sieht eine zylinderförmige Ausprägung des Gehäuses vor. Bei einer ebenfalls zylinderförmigen Ausgestaltung des Elektromotors oder des Motorgehäusemantels der Motorbaugruppe kann so eine durchgehende Zylinderform der Baugruppe aus Elektromotor bzw. Motorbaugruppe und der Aufnahmevorrichtung für die Steuerschaltung ausgebildet werden.

Das Gehäuse kann aus Kunststoff, bevorzugt mit einem eingelassenen Drahtnetz zur elektromagnetischen Abschirmung oder aus Metall ausgebildet sein. Die Bodenplatte ist bevorzugt aus Metall ausgebildet, um zum einen eine Ableitung der Wärme zu ermöglichen, und zum anderen eine Abschirmung von Magnetfeldern aus dem Elektromotor zu ermöglichen. Mit Vorteil ist die Bodenplatte aus Aluminium dargestellt.

Durch die zylinderförmige Ausgestaltung ist es weiterhin möglich, als Gehäuse ein einfaches zylindrisches Rohr zu verwenden.

Bevorzugt ist an der Bodenplatte ein Sensor zur Detektion einer Eigenschaft des Elektromotors, insbesondere ein Rotorpositionssensor für die Antriebswelle des Elektromotors, vorgesehen. So kann hier ein kompakter Aufbau mit einer staubsicheren Abdichtung auch des Sensors erreicht werden.

Eine dauerfeste Verbindung zwischen der Aufnahmevorrichtung und dem Elektromotor kann dadurch erreicht werden, dass die Bodenplatte einen Verbindungsbereich zum dauerfesten Verbinden der Bodenplatte mit dem Elektromotor oder der Motorbaugruppe aufweist, bevorzugt durch Verkleben, Verlöten, Verschweißen, Verschrauben oder Verpressen. Insbesondere kann die Bodenplatte durch Einpressen, Kleben oder auf eine andere Weise mit dem Motorgehäusedeckel verbunden werden. Mit besonderem Vorteil kann die Verbindung über den Motorgehäusemantel, der mit dem Motorgehäusedeckel verbunden ist, erfolgen. Bei entsprechender Auslegung der elektrischen Kontakte kann deren Bonding auch eine Sicherung der Verbindung zwischen Bodenplatte und Motorgehäusedeckel bilden.

In einer Weiterbildung kann zum dauerfesten Verbinden an der Bodenplatte auch ein Verbindungselement vorgesehen sein, welches mit einem korrespondierenden Verbindungselement des Elektromotors dauerhaft verbindbar ist, bevorzugt durch eine Montageöffnung hindurch.

Die oben genannte Aufgabe wird weiterhin auch durch ein Verfahren mit den Merkmalen des Anspruchs 15 gelöst.

Entsprechend wird ein Verfahren zur Verbindung einer oben beschriebenen Aufnahmevorrichtung mit einer einen Elektromotor umfassenden Motorbaugruppe vorgeschlagen, umfassend die Schritte:
- Verbinden der Bodenplatte der Aufnahmevorrichtung in der Lieferposition mit der Motorbaugruppe, bevorzugt durch Einbringen eines Verbindungsbereichs der Bodenplatte in einen Hülsenabschnitt der Motorbaugruppe,
- Verbinden von durch die Bodenplatte hindurch geführten Kontakten der Steuervorrichtung mit korrespondierenden Kontakten des Elektromotors, bevorzugt durch eine in der Bodenplatte aufgenommenen Montageöffnung hindurch,
- Verschließen der Aufnahmevorrichtung durch Bewegen des Gehäuses relativ zur Bodenplatte von der Lieferposition in die Endposition, bevorzugt durch lineares Aufschieben eines zylinderförmigen Gehäuses auf die Bodenplatte von der Lieferposition in die Endposition.

### Kurze Beschreibung der Figuren

Bevorzugte weitere Ausführungsformen und Aspekte der vorliegenden Erfindung werden durch die nachfolgende Beschreibung der Figuren näher erläutert. Dabei zeigen:
- Figur 1: eine schematische Ansicht einer Aufnahmevorrichtung mit einer nicht dargestellten darin aufgenommenen Steuerschaltung in einer Lieferposition, geeignet zur Montage an einen nicht dargestellten Elektromotor zum Aufbringen einer Hilfskraft auf eine Fahrzeuglenkung;
- Figur 2: die Aufnahmevorrichtung der Figur 1 in einem Vormontagezustand mit einer Motorbaugruppen einer schematischen perspektivischen Ansicht, wobei sich die Aufnahmevorrichtung in einer Lieferposition befindet;
- Figur 3: eine schematische perspektivische Ansicht der Aufnahmevorrichtung der Figuren 1 und 2 in der Lieferposition beim dauerhaften Verbinden von Kontakten der in der Aufnahmevorrichtung aufgenommenen Steuerschaltung mit Kontakten des nicht dargestellten Elektromotors, der in der Motorbaugruppe aufgenommen ist;
- Figur 4: eine schematische perspektivische Ansicht der Aufnahmevorrichtung und der Motorbaugruppe der Figuren 1 bis 3, wobei sich die Aufnahmevorrichtung der Endposition befindet;
- Fig. 5: eine schematische Seitenansicht einer Aufnahmevorrichtung mit einer darin aufgenommenen Steuerschaltung zum Ansteuern eines nicht gezeigten Elektromotors, der in einer gezeigten Motorbaugruppe angeordnet ist, zum Aufbringen einer Hilfskraft auf eine Fahrzeuglenkung;
- Figur 6: eine schematische perspektivische Darstellung einer Aufnahmevorrichtung in Kombination mit einem nicht gezeigten Elektromotor, der in einer Motorbaugruppe angeordnet ist, einer Hilfskraftunterstützung einer Fahrzeuglenkung in einer entlang der Zylinderachse der Gehäuse auseinandergezogenen schematischen Darstellung;
- Figur 7: eine schematische perspektivische Darstellung einer Aufnahmevorrichtung mit darin aufgenommener Steuerschaltung ohne Bodenplatte;
- Figur 8: eine schematische perspektivische Darstellung einer Motorbaugruppe einer Hilfskraftunterstützung einer Fahrzeuglenkung und einer Bodenplatte für die Aufnahmevorrichtung der Figur 7;
- Figur 9: eine schematische perspektivische Darstellung der Aufnahmevorrichtung und der Bodenplatte der Aufnahmevorrichtung der Figur 7 in Verbindung mit der Motorbaugruppe der Figur 8 zur Veranschaulichung der Anordnung der Komponenten; und
- Figur 10: eine schematische perspektivische Darstellung einer Ausführungsform der Bodenplatte; und
- Figur 11: eine schematische Darstellung eines separaten Hakenteils als Sicherungsteil zur Bildung einer Verbindungssicherung.

### Detaillierte Beschreibung bevorzugter Ausführungsbeispiele

Im Folgenden werden bevorzugte Ausführungsbeispiele anhand der Figuren beschrieben. Dabei werden gleiche, ähnliche oder gleichwirkende Elemente in den unterschiedlichen Figuren mit identischen Bezugszeichen bezeichnet und auf eine wiederholte Beschreibung dieser Elemente wird in der nachfolgenden Beschreibung teilweise verzichtet, um Redundanzen zu vermeiden.

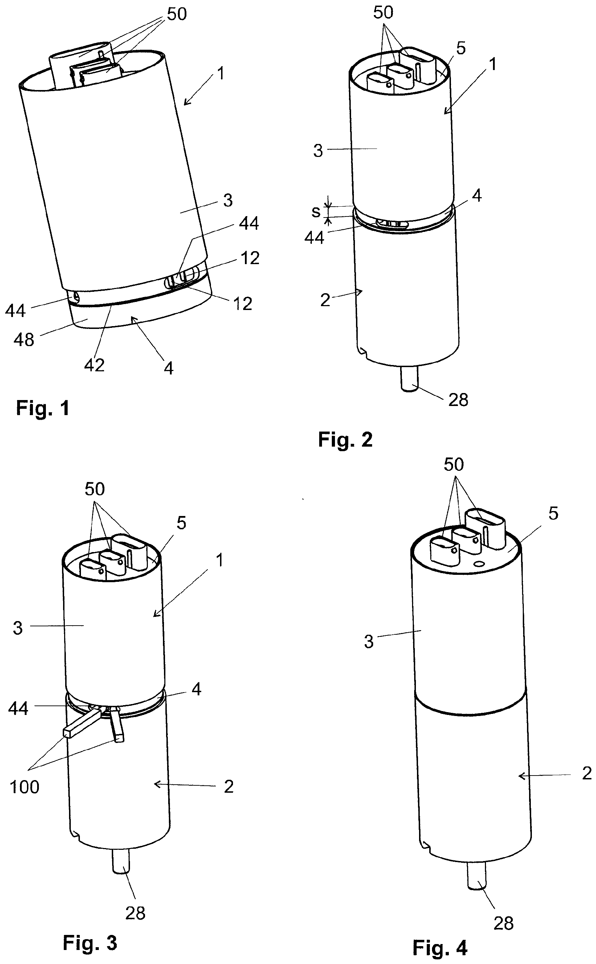

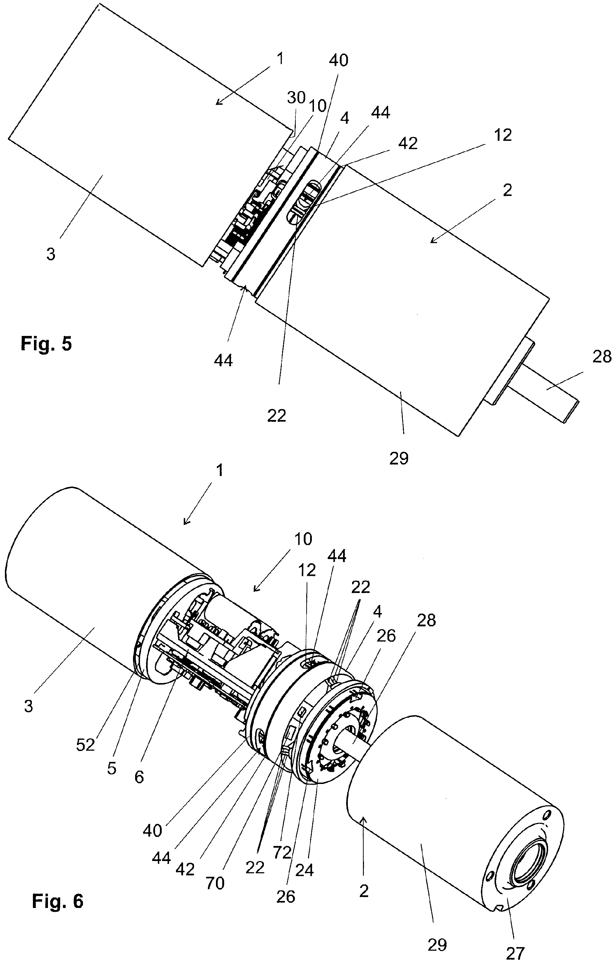

In den Figuren 1 bis 5 ist ein erstes Ausführungsbeispiel gezeigt. Figur 5 ist eine schematische seitliche Ansicht einer Aufnahmevorrichtung 1, welche zur Aufnahme einer schematisch angedeuteten Steuerschaltung 10 vorgesehen ist, gezeigt. Die Aufnahmevorrichtung 1 ist in Kombination mit einem Elektromotor, hier als Motorbaugruppe 2 dargestellt, für eine Hilfskraftunterstützung einer Fahrzeuglenkung dargestellt. Die Baugruppe umfassend die Aufnahmevorrichtung 1 mit der darin aufgenommenen Steuerschaltung 10 und der Motorbaugruppe 2 dient dazu, über die Antriebswelle 28 des Elektromotors eine Hilfskraft beziehungsweise ein Hilfsdrehmoment auf eine hier nicht gezeigte Fahrzeuglenkung aufzubringen. Zwischen die Antriebswelle 28 und die eigentliche Fahrzeuglenkung kann noch ein Getriebe der Hilfskraftunterstützung zwischengeschaltet werden, um Drehzahl und Drehmoment des Elektromotors an die von der Fahrzeuglenkung geforderten Werte anzupassen.

Die Steuerschaltung 10 zur Ansteuerung des Elektromotors umfasst typischer Weise eine Motorsteuerung, welche entsprechend Leistungsschalter aufweist. Beispielsweise kann je Motorphase ein MOSFET vorgesehen sein, mittels welchem der Leistungsstrom, welcher dem Elektromotor zugeführt wird, gesteuert wird. Die benötigte elektrische Leistung sowie Steuersignale zur Ansteuerung der Motorsteuerung werden über Steckverbindungen 50, welche sich in einer Stirnplatte 5 der Aufnahmevorrichtung 1 befinden, der Steuerschaltung 10 zugeführt.

Die Baugruppe aus Aufnahmevorrichtung 1 mit der darin aufgenommenen Steuerschaltung 10 und der Motorbaugruppe 2 kann in Verbindung mit einer Fahrzeuglenkung dazu dienen, eine Hilfskraft beziehungsweise ein Hilfsdrehmoment aufzubringen, welches die von einem Fahrer über das Lenkrad eingebrachte Lenkkraft reduziert. Der Fahrer wird entsprechend bei der Lenkbewegung unterstützt. Zusätzlich oder alternativ kann bei einer Überlagerungslenkung auch ein weiterer Lenkwinkel aufgebracht werden, beispielsweise zur Durchführung einer automatischen oder unterstützten Spurhaltung oder beim automatischen Einparken des Fahrzeugs, oder zur Änderung der Lenkübersetzung.

Die Aufnahmevorrichtung 1 weist ein Gehäuse 3 auf, welches, wie sich beispielsweise auch aus den Figuren 1 bis 4 ergibt, im Wesentlichen als zylinderförmige Hülse ausgebildet ist. Diese zylinderförmige Hülse kann beispielsweise von einem einen entsprechenden Durchmesser aufweisenden Rohr abgelängt sein, so dass sich eine einfache Herstellung des Gehäuses 3 ergibt. Das Gehäuse 3 ist bevorzugt aus einem Kunststoffmaterial ausgebildet, in welches zur Abschirmung gegen elektromagnetische Strahlung bevorzugt ein Drahtnetz eingelegt ist. Das Gehäuse 3 kann aber auch vollständig aus Metall ausgebildet sein. In das Gehäuse 3 ist die Steuerschaltung 10 zur Ansteuerung des Elektromotors, der in der Motorbaugruppe 2 angeordnet ist, über eine Öffnung 30 des Gehäuses 3 eingeführt und damit in dem Gehäuse 3 aufgenommen.

Eine Bodenplatte 4 ist vorgesehen, welche die Öffnung 30 des Gehäuses 3 staubdicht verschließen kann. Dieser staubdichte Verschluss der Öffnung 30 des Gehäuses 3 findet in einer Endposition, also einer endgültigen Relativposition des Gehäuses 3 zur Bodenplatte 4, statt. Diese Endposition ist beispielsweise in Figur 4 gezeigt, in welcher die Bodenplatte 4 in dem Gehäuse 3 aufgenommen ist. In der Endposition ist die gezeigte Baugruppe aus Aufnahmevorrichtung 1 mit der darin aufgenommenen Steuerschaltung 10 und der Motorbaugruppe 2 mit darin aufgenommenem nicht einzeln dargestellten Elektromotor zum Betrieb in einem Fahrzeug zur Hilfskraftunterstützung der Fahrzeuglenkung bereit und eine vollständige Abdichtung der einzelnen Komponenten ist gegeben.

Um eine sichere und zuverlässige Verbindung von Aufnahmevorrichtung 1 und Motorbaugruppe 2 zu ermöglichen, weist die Aufnahmevorrichtung 1 aber auch eine Lieferposition auf, in welcher das Gehäuse 3 relativ zur Bodenplatte 4 zurückgezogen ist, so wie in den Figuren 1 und 2 zu erkennen. In dieser Lieferposition wird die Aufnahmevorrichtung 1 mit der darin aufgenommenen Steuerschaltung 10 angeliefert, wie dies in Figur 1 dargestellt ist. Die Aufnahmevorrichtung 1 kann dann mit dem Elektromotor beziehungsweise der Motorbaugruppe 2 verbunden werden, entsprechend Figur 2. Auch in der Lieferposition ist das Gehäuse 3 beziehungsweise die Gehäuseöffnung 30 durch die Bodenplatte 4 staubdicht abgeschlossen, so dass beim Transport der Aufnahmevorrichtung 1 und beim Verbinden der Aufnahmevorrichtung 1 mit dem Elektromotor beziehungsweise der Motorbaugruppe 2 kein Staub, keine Späne und kein weiterer Schmutz in das Gehäuse 3 eindringen kann und entsprechend keine Gefahr der Kontaminierung der Steuerschaltung 10 besteht. Damit kann die Sicherheit und Zuverlässigkeit der Baugruppe erhöht werden.

Wie sich beispielsweise aus Figur 1 und Figur 2 ergibt, weist die Bodenplatte 4 eine erste Dichtung 40 (vergleiche Figur 5 oder 6) und eine zweite Dichtung 42 auf. Die erste Dichtung 40 dient zur staubdichten Abdichtung in der Lieferposition und die zweite Dichtung 42 dient zur weiteren staubdichten Abdichtung in der Endposition.

An den Positionen der ersten Dichtung 40 und der zweiten Dichtung 42 können auch Rastvorrichtungen vorgesehen sein, welche mit entsprechenden dazu komplementären Rastvorrichtungen an der Innenwand des Gehäuses 3 wechselwirken und welche dazu dienen, das Gehäuse 3 relativ zur Bodenplatte 4 in der Lieferposition und in der Endposition zuverlässig zu verrasten. Hierzu können beispielsweise nicht gezeigte nach innen gerichtete Vorsprünge im Gehäuse 3 mit nicht gezeigten Vertiefungen am Umfang der Bodenplatte 4 ausgebildet sein.

Aus den Figuren 2 und 3 ergibt sich, dass das Gehäuse 3 in der Lieferposition nicht vollständig auf die Bodenplatte 4 aufgeschoben ist, sondern ein Spalt s verbleibt, welcher in etwa dem Abstand der Dichtungen 40, 42 in Axialrichtung des zylinderförmigen Gehäuses 3 entspricht. Um das Gehäuse 3 in die Endposition zu bringen, so wie sie beispielsweise in Figur 4 gezeigt ist, wird das Gehäuse 3 entsprechend relativ zur Bodenplatte 4 um die dem Spalt s entsprechende Strecke zur Motorbaugruppe 2 hin verschoben, so dass der Spalt s durch das Gehäuse 3 verschlossen wird. Die Bodenplatte 4 ist dann vollständig im Gehäuse 3 der Aufnahmevorrichtung 1 und auch in einem Hülsenabschnitt 20, der durch einen Motorgehäusemantel 29 der Motorbaugruppe 2 gebildet ist, aufgenommen. Aus Figur 4 ist zu erkennen, dass in dem gezeigten Ausführungsbeispiel entsprechend die Baugruppe bestehend aus der Aufnahmevorrichtung 1, in welcher die Steuerschaltung 10 aufgenommen ist, und der Motorbaugruppe 2 nach außen hin eine zylindrische Form ausbilden, an deren einem Ende die Antriebswelle 28 des Elektromotors austritt und an deren anderem Ende die Steckverbindungen 50 austreten.

Die Steuerschaltung 10 umfasst Kontakte 12 zur Kontaktierung des Elektromotors, mittels welchen die Leistungsströme an die entsprechenden Wicklungen des Elektromotors weitergegeben werden sollen. Neben diesen Kontakten 12 können auch weitere Kontakte 12 vorgesehen sein, welche beispielsweise zur Übertragung von Sensorsignalen von dem Elektromotor oder an den Elektromotor dienen. Diese Kontakte 12 der Steuerschaltung werden durch die Bodenplatte 4 hindurchgeführt, so dass sie auf der Unterseite der Bodenplatte 4 wieder austreten. Die Durchführungen sind bevorzugt staubdicht abgedichtet.

Die Kontakte 12 der Steuerschaltung 10 treten so aus der Bodenplatte 4 aus, dass sie mit den korrespondierenden Kontakten 22 des Elektromotors 2 in Verbindung kommen, an diesen anliegen oder diesen direkt gegenüber liegen. In der Bodenplatte 4 ist mindestens eine Montageöffnung 44 vorgesehen, durch welche hindurch auf die aneinander anliegenden Kontakte 12, 22 zugegriffen werden kann. Die Kontakte 12, 22 sind entsprechend über die Montageöffnung 44 auch dann zugänglich, wenn die Aufnahmevorrichtung 1 in der Lieferposition ist und die Bodenplatte 4 bereits mit dem Elektromotor beziehungsweise der Motorbaugruppe 2 verbunden ist. Die Montageöffnung 44 ist damit bevorzugt seitlich in der Bodenplatte 4 eingebracht, so dass radial durch die Montageöffnung 44 hindurch auf die Kontakte 12, 22 zugegriffen werden kann.

In Figur 3 ist ein Zustand gezeigt, in welchem durch die Montageöffnungen 44 hindurch mittels eines Schweißwerkzeugs 100 auf die Kontakte 12, 22 zugegriffen wird, um diese Kontakte dauerfest miteinander zu verbinden. Eine solche dauerhafte Verbindung der Kontakte 12, 22 kann beispielsweise durch Verlöten, Verschweißen, Krimpen oder andere Bonding-Verfahren erreicht werden. Da der Zugriff auf die Kontakte 12, 22 im Lieferzustand der Aufnahmevorrichtung 1 ermöglicht wird, ist die Steuerschaltung 10 vollkommen staubdicht geschützt in der Aufnahmevorrichtung 1 aufgenommen. Etwaige Verschmutzungen, die durch den Prozess des dauerhaften Verbindens der Kontakte 12, 22 auftreten, können daher die Steuerschaltung 10 nicht beeinträchtigen.

Im Bereich der ersten Dichtung 40 und der zweiten Dichtung 42 ist bevorzugt eine erste Rastung für die Lieferposition und eine zweite Rastung für die Endposition vorgesehen. Entsprechend kann das zylinderförmige Gehäuse 3 auf die Bodenplatte 4 so weit aufgeschoben werden, bis die Lieferposition durch Verrasten mit der ersten Rastung erreicht wird. In diesem Zustand ist die Aufnahmevorrichtung 1, welche dann die Steuerschaltung 10 umfasst, in einem Zustand ausgebildet, in welchem die Steuerschaltung 10 staubdicht gegenüber der Umgebung abgedichtet ist und im Inneren des zylinderförmigen Gehäuses 3 vorliegt.

Obwohl in Figur 5 eine Darstellung gezeigt ist, in welcher die Steuervorrichtung 10 noch zu erkennen ist und entsprechend die Lieferposition noch nicht erreicht wird, ist dies lediglich als exemplarische Darstellung zu verstehen. Üblicherweise wird die Steuerschaltung 10 in dem Gehäuse 3 mit der Bodenplatte 4 in einem separaten Reinraum beziehungsweise einer separaten Montageeinheit so montiert, dass ein Eintreten von Staub, Schmutz oder Spänen in das Innere des Gehäuses 3 wirkungsvoll unterbunden wird. Die Aufnahmevorrichtung 1, in welcher die Steuerschaltung 10 aufgenommen ist, wird dann entsprechend zur Montage mit dem Elektromotor 2 in dem in Figur 1 gezeigten Zustand geliefert, also mit dem Gehäuse 3 und der Bodenplatte 4 in der Lieferposition, in welcher entsprechend ein vollständiges Abdichten des Innenraumes erreicht wird. Beim nachfolgenden Montieren des Elektromotors beziehungsweise der Motorbaugruppe 2 an der Aufnahmevorrichtung 1 kann entsprechend kein weiterer Staub, Schmutz oder Späne in das Innere des Gehäuses 3 eindringen, so dass die Steuerschaltung 10 im Wesentlichen staubfrei in der Aufnahmevorrichtung 1 gehalten wird.

Insbesondere kann auch durch das Verbinden der Steuerschaltung 10 mit dem Elektromotor beziehungsweise der Motorbaugruppe 2 und insbesondere das Verbinden der Kontakte 12 der Steuerschaltung 10 mit den Kontakten 22 des Elektromotors durch entsprechende Bonding-Techniken, wie Löten, Schweißen, Krimpen, keine Fremdkörper in das Gehäuse 3 eingetragen werden, da dieses bereits staubdicht abgeschlossen ist. Hiermit kann sichergestellt werden, dass bei der Montage beziehungsweise der Hochzeit von Elektromotor beziehungsweise Motorbaugruppe 2 und Aufnahmevorrichtung 1, in welcher die Steuerschaltung 10 aufgenommen ist, die Steuerschaltung 10 nicht kompromittiert wird.

Nach dem in Figur 3 gezeigten Schritt des dauerfesten Verbindens der Kontakte 12, 22 miteinander, beispielsweise durch das gezeigte Verschweißen mittels des Schweißwerkzeugs 100, wird, wie in Figur 4 gezeigt, das Gehäuse 3 dann in die Endposition bewegt, so dass auch eine Abdichtung der Montageöffnung 44 erfolgt.

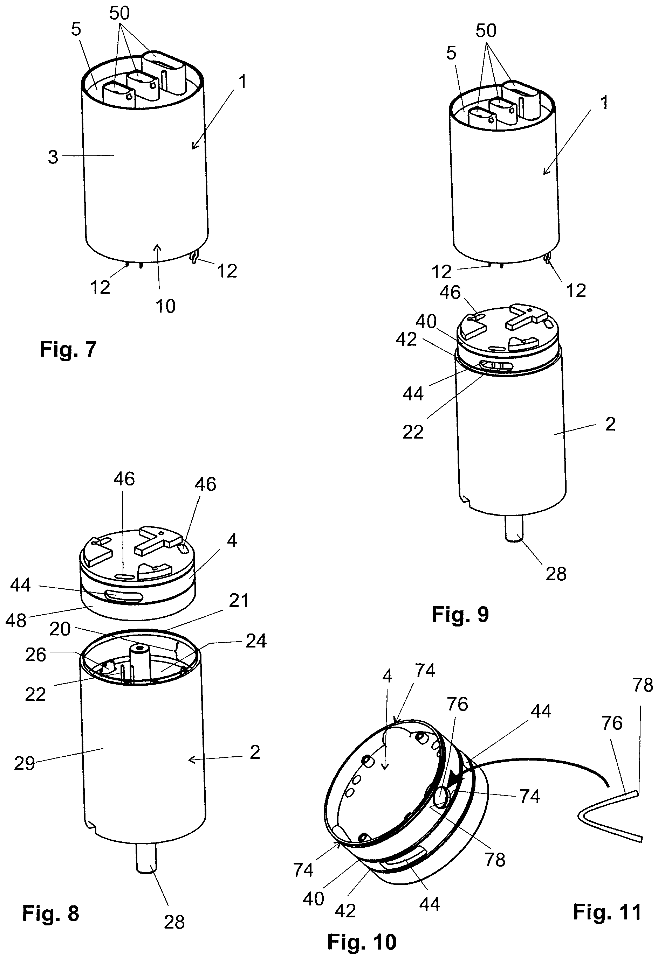

Die Montageöffnung 44 liegt, wie beispielsweise aus Figur 1 und 8 zu erkennen, zwischen den Dichtungen 40, 42, so dass durch ein vollständiges Aufschieben des zylinderförmigen Gehäuses 3 auf die Bodenplatte 4 das Gehäuse 3 mit beiden Dichtungen 40, 42 in Kontakt kommt und damit auch die Montageöffnung 44 staubdicht im Gehäuse 3 aufgenommen ist.

Bevorzugt ist eine manipulationssichere Verbindung zumindest in der in den Figuren 1, 2 und 3 gezeigten Lieferposition der Aufnahmevorrichtung 1 vorgesehen. Die manipulationssichere Verbindung kann beispielsweise dadurch dargestellt werden, dass beim erneuten Öffnen des Gehäuses 3 gegenüber der Bodenplatte 4, ausgehend von der Lieferposition, mittels eines Widerhakens beispielsweise die erste Dichtung 40 durchtrennt wird. Damit ist es in einem nachfolgenden Montageschritt sofort erkennbar, ob es sich bei der Aufnahmevorrichtung 1, welche mit einer Motorbaugruppe 2 verbunden werden soll, um eine solche handelt, die sich im ursprünglichen Lieferzustand befindet, von der also ausgegangen werden kann, dass sich die Steuerschaltung 10 in einem staubfreien Raum innerhalb des Gehäuses 3 befindet, oder ob eine solche im Wesentlichen staubfreie Aufnahme der Steuervorrichtung 10 nicht sichergestellt werden kann, da die Aufnahmevorrichtung 1 unsachgemäß geöffnet wurde. Hierfür können in einer Ausführungsform der Aufnahmevorrichtung 1 entsprechend Figuren 10 und 11 eine oder mehrere Vertiefungen 74 in der Bodenplatte 4 vorgesehen sein, in die jeweils ein Hakenelement 76 eingeführt ist, dessen Haken 78 jeweils mit einem nicht dargestellten Vorsprung im Gehäuse, der nach innen gerichtet ist, zusammenwirkt. Der Pfeil zwischen den Figuren 10 und 11 veranschaulicht, wie das Hakenelement 76 in die Vertiefung 74 eingelegt wird. Das Hakenelement 76 kann als einfaches rundes gefaltetes Blechteil ausgebildet sein, wie es die Figur 11 in einer Seitenansicht veranschaulicht. Der Haken 78 wird dann durch einen Endbereich dargestellt und sollte in der eingelegten Position in Richtung der Verschiebung des Gehäuses 3 bei der Montage ausgerichtet sein, um beim Öffnungsversuch durch Abziehen des Gehäuses 3 einen Widerhaken zu bilden.

In den Figuren 7 bis 9 ist die Aufnahmevorrichtung 1 in weiteren Darstellungen gezeigt, wobei in Figur 5 lediglich das Gehäuse 3 mit den aus dem Gehäuse 3 nach unten heraus stehenden Kontakten 12 gezeigt ist. Eine Stirnplatte 5, an welcher Steckverbindungen 50 vorgesehen sind, mittels welcher die Steuerschaltung 10 kontaktiert werden kann und entsprechend eine Verbindung zu einer übergeordneten Kraftfahrzeugsteuerung sowie der Stromversorgung erreicht werden kann, ist ebenfalls vorgesehen.

Das Gehäuse 3 der Aufnahmevorrichtung 1 ist bevorzugt aus einem Kunststoffmaterial hergestellt. In das Kunststoffmaterial ist bevorzugt ein Drahtnetz eingearbeitet, um elektromagnetische Störungen von der Steuerschaltung 10 fortzuhalten. In einer weiteren bevorzugten Variante ist das Gehäuse 3 aus Metall ausgebildet, bevorzugt aus Aluminium.

Das Gehäuse 3 ist weiterhin bevorzugt vollständig zylindrisch ausgebildet, so dass ein leichtes Aufschieben des Gehäuses 3 auf die Bodenplatte 4 erreicht werden kann und entsprechend ein Aufschieben von der Lieferposition in die Endposition ermöglicht wird.

In Figur 8 ist die Bodenplatte 4 einzeln über der Motorbaugruppe 2 gezeigt, so dass zu erkennen ist, wie die Bodenplatte 4 mit der Motorbaugruppe 2 verbunden werden kann. Die Bodenplatte 4 kann in einem Verbindungsbereich 48 in den Hülsenabschnitt 20 des Motorgehäusemantels 29 der Motorbaugruppe 2 eingeschoben werden, um eine Verbindung zwischen Aufnahmevorrichtung 1 und Elektromotor beziehungsweise Motorbaugruppe 2 herzustellen. Der Verbindungsbereich 48 kann zur Verbindung entweder in den Hülsenabschnitt 20 der Motorbaugruppe 2 eingepresst werden, oder mit dieser verklebt, verlötet, verschweißt oder verschraubt werden. Um auch hier eine zumindest staubdichte Verbindung herzustellen, kann eine Dichtung 21 in dem Hülsenabschnitt 20 der Motorenbaugruppe 2 vorgesehen sein, welche eine Abdichtung zwischen Bodenplatte 4 und Elektromotor 2 bereitstellt.

Der Elektromotor hat Kontakte 22 zur Kontaktierung von Wicklungen des Elektromotors, beispielsweise einer Stator- oder einer Läuferwicklung, oder von im Motor aufgenommenen Sensoren. Die Kontakte 22 stehen aus einem Motorgehäusedeckel, der als Lagerungsplatte 24 ausgebildet ist, der Motorbaugruppe 2 heraus. Die Montageöffnung 44 der Bodenplatte 4 wird bei deren Verbindung mit dem Elektromotor beziehungsweise der Motorbaugruppe 2 entsprechend so ausgerichtet, dass die zu den Kontakten 22 des Elektromotors korrespondierenden Kontakte 12 der Steuerschaltung 10 richtig ausgerichtet sind. Die Kontakte 12, 22 sind dann derart aneinander anliegend oder in der Nähe angeordnet, dass sie mittels entsprechender Werkzeuge durch die Montageöffnung 44 in der Bodenplatte 4 hindurch miteinander verbunden werden können.

Die Kontakte 12 der Steuerschaltung 10 werden beim Einbau der Bodenplatte 4 in das Gehäuse 3, bevorzugt in einem Reinraum, durch entsprechende Kontaktdurchlässe 46 in der Bodenplatte 4 hindurchgeführt und diese Kontaktdurchlässe 46 mit den darin aufgenommenen Kontakten 12 werden abgedichtet. Die Kontaktdurchführungen 46 sind korrespondierend zu den Montageöffnungen 44 ausgerichtet, so dass durch die Montageöffnung 44 hindurch ein Zugriff auf die Kontakte 12 der Steuerschaltung 10 sowie der Kontakte 22 des Elektromotors 2 erreicht werden kann.

Die Lagerungsplatte 24 des Elektromotors der Motorbaugruppe 2, welche zur Lagerung der Antriebswelle 28 dient, ist ebenfalls mit Kontaktdurchführungen 26 versehen, durch welche hindurch die Kontakte 22 des Elektromotors geführt werden können. Die entsprechenden Kontaktdurchführungen 26 sind auch abgedichtet.

Die Lagerungsplatte 24 ist weiterhin besonders bevorzugt als Abschirmung für die in dem Elektromotor entstehenden Magnetfelder ausgeführt ("B-shield"), so dass ein übermäßiges Eintragen des Magnetfelds aus dem Elektromotor beziehungsweise der Motorbaugruppe 2 in die Steuerschaltung 10 verhindert werden kann. Auch die Bodenplatte 4 kann mit einer solchen Abschirmwirkung ausgebildet sein. Mit Vorzug sind weitere Funktionen in die Lagerungsplatte 24 integriert. Beispielsweise können die Windungen des Elektromotors an nicht gezeigten Umlenkelementen der Lagerungsplatte geführt und gehalten werden.

In Figur 9 ist gezeigt, wie die Bodenplatte 4 mit der Motorbaugruppe 2 verbunden wird. Der Verbindungsbereich 48 ist entsprechend vollständig in dem Hülsenabschnitt 20 des Motorgehäusemantels 29 der Motorbaugruppe 2 eingeschoben. Diese Darstellung dient nur zur Veranschaulichung und stellt keinen bevorzugten Verfahrensschritt dar. In dieser Anordnung müsste, wie bereits jetzt im Stand der Technik, die Baugruppe aus Steuerschaltung und Elektromotor mit ihren entsprechenden Gehäusen in einem Reinraum montiert werden.

In Figur 6 ist die Baugruppe bestehend aus der Aufnahmevorrichtung 1 und dem Elektromotor 2 in einer auseinandergezogenen Ansicht dargestellt, in welcher die unterschiedlichen Elemente gut zu erkennen sind.

Das Gehäuse 3 ist in Figur 6 in einer vollständig zurückgezogenen Position gezeigt, wobei es hier über die Stirnplatte 5 hinaus gezogen ist. Eine Dichtung 52 am Umfang der Stirnplatte 5 ermöglicht eine staubdichte Abdichtung des Gehäuses 3 gegenüber der Stirnplatte 5 derart, dass das Volumen des Gehäuses 3 staubdicht gegenüber der Umgebung abgeschirmt werden kann. Mittels der Dichtung 52 ist das Gehäuse 3 auch gegenüber der Stirnplatte 5 verschiebbar. Mit anderen Worten kann das hülsenförmig ausgebildete Gehäuse 3 sowohl gegenüber der Bodenplatte 4 als auch gegenüber der Stirnplatte 5 in axialer Richtung verschoben werden. Durch diese Verschiebung kann die Bewegung des Gehäuses 3 relativ zur Bodenplatte 4 von der Lieferposition in die Endposition erreicht werden. Dabei wird das Gehäuse 3 auf die Bodenplatte 4 soweit aufgeschoben, dass das Gehäuse 3 an die Hülse 20 des Elektromotors 2 anstößt.

Ein Trägerelement 6 ist vorgesehen, an welchem die Steuerschaltung 10 aufgebracht ist. Das Trägerelement 6 ist bevorzugt wärmeleitend ausgebildet und ist bevorzugt wärmeleitend mit der Stirnplatte 5 und/oder der Bodenplatte 4 verbunden, um ein Ableiten von durch die Steuerschaltung 10 und insbesondere die Leistungsschaltelemente der Steuerschaltung 10 erzeugter Wärme über die Stirnplatte 5 und/oder die Bodenplatte 4 zu ermöglichen.

In der in Figur 6 gezeigten Darstellung kann von unten in die Bodenplatte 4 hereingesehen werden und es sind die Kontakte 22 des Elektromotors 2 zu sehen, welche mit den von oben eingebrachten Kontakten 12 der Steuerschaltung 10 verbunden werden sollen.

Als Kontakt 22 kann direkt ein Draht einer Motorwicklung verwendet werden, so dass die Kontaktierung durch Vermeidung zusätzlicher Verbindungen zuverlässiger wird. Auf eine Motorkrone kann verzichtet werden. Bei dem Elektromotor 2 sind sämtliche Anschlüsse bevorzugt auf einer Seite, also der der Aufnahmevorrichtung 1 zugewandten Seite, angeordnet. Auf diese Weise wird die Kontaktierung zwischen dem Elektromotor und der Steuerschaltung 10 in der Aufnahmevorrichtung 1 vereinfacht. Die Positionierung und das Halten des Drahts der Motorwicklung kann dabei von der Lagerungsplatte 24 übernommen werden, wobei die entsprechenden Drähte nur so gehalten werden müssen, dass sie mit den Kontakten 12 der Steuerschaltung 10 dauerfest verbindbar sind.

Bevorzugt erstreckt sich die Abtriebswelle 28, so wie sich beispielsweise aus der Figur 8 ergibt, über die Lagerungsplatte 24 hinaus, so dass an der Unterseite der Bodenplatte 4 ein schematisch angedeuteter Rotationspositionssensor 70 (RPS) vorgesehen sein kann, welcher mit einem entsprechenden, mit der Motorwelle 28 verbundenen Geber 72 in Wirkverbindung steht. Durch den Rotationspositionssensor können entsprechend Daten einer Rotation sowie einer Positionierung der Antriebswelle 28 des Elektromotors 2 an die Steuerschaltung 10 übertragen werden. Der Rotationspositionssensor 70 kann dabei entweder direkt über einen Kontaktierungsdurchlass in der Bodenplatte 4 an die Steuerschaltung 10 angebunden sein, oder aber er kann induktiv an einen entsprechenden, auf der Innenseite, also innerhalb des Gehäuses 3 in der Endposition liegenden Sensor angekoppelt sein.

In einer nicht gezeigten Weiterbildung sind an der Bodenplatte 4 neben den Kontakten 12 Verbindungselemente vorgesehen, beispielsweise in Form von herausstehenden Zapfen, die mit korrespondierenden Verbindungselementen des Elektromotors beziehungsweise der Motorbaugruppe dauerhaft verbindbar sind. Die Verbindungselemente des Elektromotors beziehungsweise der Motorbaugruppe 2 können beispielsweise auch in Form von sich von der Lagerplatte 24 aus erstreckenden Zapfen vorliegen. Die Verbindungselemente der Bodenplatte 4 und der Lagerplatte 24 werden dann bevorzugt durch eine Montageöffnung 44 hindurch unter Einsatz eines entsprechenden Werkzeugs verbunden, beispielsweise durch Verschweißen. Auf diese Weise wird eine sichere Verbindung zwischen der Bodenplatte 4 und damit der Aufnahmevorrichtung 1 und der Motorbaugruppe 2 beziehungsweise dem Elektromotor hergestellt. Die Kontaktierungen der miteinander verbundenen Kontakte 12, 22 werden durch diese weiteren Verbindungen mechanisch entlastet.

Soweit anwendbar, können alle einzelnen Merkmale, die in den einzelnen Ausführungsbeispielen dargestellt sind, miteinander kombiniert und/oder ausgetauscht werden, ohne den Bereich der Erfindung zu verlassen.

### Bezugszeichenliste

- 1: Aufnahmevorrichtung
- 10: Steuerschaltung
- 12: Kontakt
- 100: Schweißwerkzeug
- 2: Elektromotor
- 20: Hülsenabschnitt
- 21: Dichtung
- 22: Kontakt
- 24: Lagerplatte
- 26: Kontaktdurchlass
- 27: Motorgehäuseplatte
- 28: Antriebswelle
- 29: Motorgehäusemantel
- 3: Gehäuse
- 30: Öffnung
- 4: Bodenplatte
- 40: erste Dichtung
- 42: zweite Dichtung
- 44: Montageöffnung
- 46: Kontaktdurchlass
- 48: Verbindungsbereich
- 5: Stirnplatte
- 50: Steckverbindung
- 52: Dichtung
- 6: Trägerelement
- 70: Rotationspositionssensor
- 72: Geber
- 74: Aussparung
- 76: Hakenelement
- 78: Haken

- s: Spalt

## Patentansprüche

1. Aufnahmevorrichtung (1) für eine einen Elektromotor einer Hilfskraftunterstützung einer Fahrzeuglenkung ansteuernden Steuerschaltung (10), umfassend ein Gehäuse (3) zur Aufnahme der Steuerschaltung (10), wobei das Gehäuse (3) eine Öffnung (30) zum Einführen der Steuerschaltung (10) in das Gehäuse (3) aufweist, und eine Bodenplatte (4) zum staubdichten Verschließen der Öffnung (30) des Gehäuses (3) in einer Endposition,
**dadurch gekennzeichnet, dass**
die Bodenplatte (4) und das Gehäuse (3) in einer von der Endposition verschiedenen Lieferposition staubdicht miteinander verbindbar sind.

2. Aufnahmevorrichtung (1) gemäß Anspruch 1, **dadurch gekennzeichnet, dass** mindestens eine Montageöffnung (44) in der Bodenplatte (4) vorgesehen ist, durch welche hindurch zumindest ein durch die Bodenplatte (4) hindurch geführter Kontakt (12) der Steuerschaltung (10) in der Lieferposition frei zugänglich ist.

3. Aufnahmevorrichtung (1) gemäß Anspruch 2, **dadurch gekennzeichnet, dass** die Montageöffnung (44) in der Endposition im Gehäuse (3) aufgenommen ist.

4. Aufnahmevorrichtung (1) gemäß einem der vorstehenden Ansprüche, **dadurch gekennzeichnet, dass** eine erste Rastvorrichtung zur Verrastung des Gehäuses (3) mit der Bodenplatte (4) in der Lieferposition, und eine zweite Rastvorrichtung zur Verrastung des Gehäuses (3) mit der Bodenplatte (4) in der Endposition vorgesehen sind.

5. Aufnahmevorrichtung (1) gemäß einem der vorstehenden Ansprüche, **dadurch gekennzeichnet, dass** eine manipulationssichere Verbindung zwischen dem Gehäuse (3) und der Bodenplatte (4) in der Lieferposition so vorgesehen ist, dass ein erneutes Öffnen der Aufnahmevorrichtung (1) erkennbar ist.

6. Aufnahmevorrichtung (1) gemäß einem der vorstehenden Ansprüche, **dadurch gekennzeichnet, dass** eine erste Dichtung (40) zum Abdichten des Gehäuses (3) gegenüber der Bodenplatte (4) in der Lieferposition und eine zweite Dichtung (42) zur Abdichtung des Gehäuses (3) gegenüber der Bodenplatte (4) in der Endposition vorgesehen ist.

7. Aufnahmevorrichtung (1) gemäß Anspruch 6, **dadurch gekennzeichnet, dass** zwischen der ersten Dichtung (40) und der zweiten Dichtung (42) eine Montageöffnung (44) vorgesehen ist, durch welche hindurch ein durch die Bodenplatte (4) hindurch geführter Kontakt (12) der Steuerschaltung (10) in der Lieferposition frei zugänglich ist.

8. Aufnahmevorrichtung (1) gemäß einem der vorstehenden Ansprüche, **dadurch gekennzeichnet, dass** ein wärmeleitendes Trägerelement (6) für die Steuerschaltung (10) vorgesehen ist, bevorzugt für zumindest ein MOSFET der Steuerschaltung (10), und das Trägerelement (6) in wärmeleitender Verbindung mit der Bodenplatte (4) und/oder einer Stirnplatte (5) steht.

9. Aufnahmevorrichtung (1) gemäß einem der vorstehenden Ansprüche, **dadurch gekennzeichnet, dass** das Gehäuse (3) im Wesentlichen zylinderförmig ausgebildet ist.

10. Aufnahmevorrichtung (1) gemäß einem der vorstehenden Ansprüche, **dadurch gekennzeichnet, dass** das Gehäuse (3) einen Kunststoff aufweist, bevorzugt einen mit einem Drahtnetz verstärkten Kunststoff, oder aus Metall ausgebildet ist.

11. Aufnahmevorrichtung (1) gemäß einem der vorstehenden Ansprüche, **dadurch gekennzeichnet, dass** die Bodenplatte (4) Metall aufweist.

12. Aufnahmevorrichtung (1) gemäß einem der vorstehenden Ansprüche, **dadurch gekennzeichnet, dass** an der Bodenplatte (4) ein Sensor zur Detektion einer Eigenschaft des Elektromotors (2), insbesondere ein Rotorpositionssensor für die Antriebswelle (28) des Elektromotors (2), vorgesehen ist.

13. Aufnahmevorrichtung (1) gemäß einem der vorstehenden Ansprüche, **dadurch gekennzeichnet, dass** die Bodenplatte (4) einen Verbindungsbereich (48) zum dauerfesten Verbinden der Bodenplatte (4) mit dem Elektromotor (2) aufweist, bevorzugt durch Verkleben, Verlöten, Verschweißen, Verschrauben oder Verpressen.

14. Aufnahmevorrichtung (1) gemäß einem der vorstehenden Ansprüche, **dadurch gekennzeichnet, dass** an der Bodenplatte (4) Verbindungselemente vorgesehen sind, die korrespondierenden Verbindungselementen des Elektromotors dauerhaft verbindbar sind, bevorzugt durch eine Montageöffnung (44) hindurch.

15. Verfahren zur Verbindung einer Aufnahmevorrichtung (1) gemäß einem der vorstehenden Ansprüche mit einem einen Elektromotor umfassenden Motorbaugruppe (2), umfassend die Schritte:
- Verbinden der Bodenplatte (4) der Aufnahmevorrichtung (1) in der Lieferposition mit der Motorbaugruppe (2), bevorzugt durch Einbringen eines Verbindungsbereichs (48) der Bodenplatte (4) in einen Hülsenabschnitt (20) der Motorbaugruppe (2),
- Verbinden von durch die Bodenplatte (4) hindurch geführten Kontakten (12) der Steuervorrichtung (10) mit korrespondierenden Kontakten (22) des Elektromotors, bevorzugt durch eine in der Bodenplatte (4) aufgenommenen Montageöffnung (44) hindurch,
- Verschließen der Aufnahmevorrichtung (1) durch Bewegen des Gehäuses (3) relativ zur Bodenplatte (4) von der Lieferposition in die Endposition, bevorzugt durch lineares Aufschieben eines zylinderförmigen Gehäuses (3) auf die Bodenplatte (4) von der Lieferposition in die Endposition.

## Claims

1. Receptacle (1) for a control circuit (10) that controls an electric motor for power assistance in a vehicle steering system, comprising a housing (3) for holding the control circuit (10), wherein the housing (3) has an opening (30) to allow insertion of the control circuit (10) into the housing (3), and a baseplate (4) for dust-tight closure of the opening (30) of the housing (3) in an end position,
**characterized in that**
the baseplate (4) and the housing (3) can be connected to one another in a dust-tight fashion in a delivery position which is different from the end position.

2. Receptacle (1) according to Claim 1, **characterized in that** at least one mounting opening (44) is provided in the baseplate (4), through which mounting opening (44) at least one contact (12), guided through the baseplate (4), of the control circuit (10) is freely accessible in the delivery position.

3. Receptacle (1) according to Claim 2, **characterized in that** the mounting opening (44) is accommodated in the housing (3) in the end position.

4. Receptacle (1) according to one of the preceding claims, **characterized in that** a first latching device for latching the housing (3) to the baseplate (4) in the delivery position, and a second latching device for latching the housing (3) to the baseplate (4) in the end position, are provided.

5. Receptacle (1) according to one of the preceding claims, **characterized in that** a tamper-proof connection is provided between the housing (3) and the baseplate (4) in the delivery position, in such a way that renewed opening of the receptacle (1) can be detected.

6. Receptacle (1) according to one of the preceding claims, **characterized in that** a first seal (40) for sealing the housing (3) with respect to the baseplate (4) in the delivery position, and a second seal (42) for sealing the housing (3) with respect to the baseplate (4) in the end position, are provided.

7. Receptacle (1) according to Claim 6, **characterized in that** a mounting opening (44), through which a contact (12), guided through the baseplate (4), of the control circuit (10) is freely accessible in the delivery position, is provided between the first seal (40) and the second seal (42).

8. Receptacle (1) according to one of the preceding claims, **characterized in that** a heat-conducting carrier element (6) is provided for the control circuit (10), preferably for at least one MOSFET of the control circuit (10), and the carrier element (6) is connected in a thermally conductive fashion to the baseplate (4) and/or to an end plate (5).

9. Receptacle (1) according to one of the preceding claims, **characterized in that** the housing (3) is of essentially cylindrical design.

10. Receptacle (1) according to one of the preceding claims, **characterized in that** the housing (3) has a plastic, preferably a plastic which is reinforced with a wire mesh, or is constructed from metal.

11. Receptacle (1) according to one of the preceding claims, **characterized in that** the baseplate (4) has metal.

12. Receptacle (1) according to one of the preceding claims, **characterized in that** a sensor for detecting a property of the electric motor (2), in particular a rotor position sensor for the drive shaft (28) of the electric motor (2), is provided on the baseplate (4).

13. Receptacle (1) according to one of the preceding claims, **characterized in that** the baseplate (4) has a connection region (48) for permanently connecting the baseplate (4) to the electric motor (2), preferably by bonding, soldering, welding, screwing or pressing.

14. Receptacle (1) according to one of the preceding claims, **characterized in that** connecting elements which can be permanently connected to corresponding connecting elements of the electric motor, preferably through a mounting opening (44), are provided on the baseplate (4).

15. Method for connecting a receptacle (1) according to one of the preceding claims, having an engine assembly (2) which comprises an electric motor, comprising the steps:
- connecting the baseplate (4) of the receptacle (1) in the delivery position to the motor assembly (2), preferably by introducing a connection region (48) of the baseplate (4) into a sleeve section (20) of the motor assembly (2),
- connecting contacts (12), guided through the baseplate (4), of the control device (10) to corresponding contacts (22) of the electric motor, preferably through a mounting opening (44) accommodated in the baseplate (4), and
- closing the receptacle (1) by moving the housing (3) relative to the baseplate (4) from the delivery position into the end position, preferably by linearly fitting a cylindrical housing (3) onto the baseplate (4), from the delivery position into the end position.

## Revendications

1. Dispositif de réception (1) pour un circuit de commande (10) commandant un moteur électrique d'une assistance d'une force auxiliaire d'une direction de véhicule, comprenant un boîtier (3) destiné à la réception du circuit de commande (10), selon lequel le boîtier (3) présente une ouverture (30), destinée à l'introduction du circuit de commande (10) dans le boîtier (3), ainsi qu'une plaque de fond (4) destinée au verrouillage, étanche à la poussière, de l'ouverture (30) du boîtier (3) dans une position terminale,
**caractérisé en ce que**
la plaque de fond (4) et le boîtier (3) peuvent être reliés l'un à l'autre, de manière étanche à la poussière, dans une position de livraison, laquelle est différente de la position terminale.

2. Dispositif de réception (1) selon la revendication 1, **caractérisé en ce qu'**au moins une ouverture de montage (44) est prévue dans la plaque de fond (4), à travers la totalité de laquelle tout au moins un contact (12) du circuit de commande (10), lequel contact est guidé à travers la totalité de la plaque de fond (4), est librement accessible dans la position de livraison.

3. Dispositif de réception (1) selon la revendication 2, **caractérisé en ce que** l'ouverture de montage (44) est logée dans la position terminale dans le boîtier (3).

4. Dispositif de réception (1) selon l'une des revendications précédentes, **caractérisé en ce que** sont prévus un premier dispositif à encliquetage, lequel est destiné à l'encliquetage du boîtier (3) avec la plaque de fond (4) dans la position de livraison, et un deuxième dispositif à encliquetage, lequel est destiné à l'encliquetage du boîtier (3) avec la plaque de fond (4) dans la position terminale.

5. Dispositif de réception (1) selon l'une des revendications précédentes, **caractérisé en ce qu'**une jonction est prévue entre le boîtier (3) et la plaque de fond (4) dans la position de livraison, laquelle jonction permet une manipulation en toute sécurité, de telle sorte qu'une nouvelle ouverture du dispositif de réception (1) peut être identifiée.

6. Dispositif de réception (1) selon l'une des revendications précédentes, **caractérisé en ce que** sont prévues une première garniture étanche (40), laquelle est destinée à réaliser l'étanchéité du boîtier (3) vis-à-vis de la plaque de fond (4) dans la position de livraison, et une deuxième garniture étanche (42), laquelle est destinée à réaliser l'étanchéité du boîtier (3) vis-à-vis de la plaque de fond (4) dans la position terminale.

7. Dispositif de réception (1) selon la revendication 6, **caractérisé en ce qu'**est prévue, entre la première garniture étanche (40) et la deuxième garniture étanche (42), une ouverture de montage (44), à travers la totalité de laquelle un contact (12) du circuit de commande (10), lequel contact est guidé à travers la totalité de la plaque de fond (4), est librement accessible dans la position de livraison

8. Dispositif de réception (1) selon l'une des revendications précédentes, **caractérisé en ce qu'**un élément de support (6) conducteur de chaleur est prévu pour le circuit de commande (10), de préférence pour tout au moins un MOSFET du circuit de commande (10), et l'élément de support (6) est en jonction conductrice de chaleur avec la plaque de fond (4) et/ou une plaque frontale (5).

9. Dispositif de réception (1) selon l'une des revendications précédentes, **caractérisé en ce que** le boîtier (3) est conçu pour l'essentiel de forme cylindrique.

10. Dispositif de réception (1) selon l'une des revendications précédentes, **caractérisé en ce que** le boîtier (3) présente une matière plastique, de préférence une matière plastique renforcée par une toile métallique, ou est conçu en métal.

11. Dispositif de réception (1) selon l'une des revendications précédentes, **caractérisé en ce que** la plaque de fond (4) présente du métal.

12. Dispositif de réception (1) selon l'une des revendications précédentes, **caractérisé en ce qu'**un capteur destiné à la détection d'une propriété du moteur électrique (2) est prévu au niveau de la plaque de fond (4), en particulier un capteur de la position du rotor pour l'arbre d'entraînement (28) du moteur électrique (2).

13. Dispositif de réception (1) selon l'une des revendications précédentes, **caractérisé en ce que** la plaque de fond (4) présente une zone de jonction (48) destinée à la jonction durable de la plaque de fond (4) avec le moteur électrique (2), de préférence par encollage, brasage, soudage, vissage ou pressage.

14. Dispositif de réception (1) selon l'une des revendications précédentes, **caractérisé en ce que** des éléments de jonction sont prévus au niveau de la plaque de fond (4), avec les éléments de jonction correspondants du moteur électrique peuvent être reliés durablement, de préférence à travers la totalité d'une ouverture de montage (44).

15. Procédé destiné à la jonction d'un dispositif de réception (1) selon l'une des revendications précédentes avec un groupe de motorisation comprenant un moteur électrique (2), lequel procédé comprend les étapes suivantes:
- la jonction de la plaque de fond (4) du dispositif de réception (1), dans la position de livraison, avec le groupe de motorisation (2), de préférence par la mise en place d'une zone de jonction (48) de la plaque de fond (4) dans une section formant manchon (20) du groupe de motorisation (2) ;
- la jonction des contacts (12) du dispositif de commande (10), lesquels contacts sont guidés à travers la totalité de la plaque de fond (4), avec des contacts (22) correspondants du moteur électrique, de préférence à travers la totalité de l'ouverture de montage (44) logée dans la plaque de fond (4) ; et
- le verrouillage du dispositif de réception (1) par le mouvement du boîtier (3), par rapport à la plaque de fond (4), depuis la position de livraison dans la position terminale, de préférence par le coulissement linéaire d'un boîtier (3) de forme cylindrique sur la plaque de fond (4), depuis la position de livraison dans la position terminale.
